# EUROPEAN PATENT APPLICATION

(11) **EP 4 621 834 A2**
(43) Date of publication of application: **24.09.2025**
(21) Application number: 25162636.2
(22) Date of filing: 10.03.2025
(51) Int. Cl.: H01L 21/67

(54) **SUBSTRATE PROCESSING METHOD AND SUBSTRATE PROCESSING APPARATUS**

(30) Priority: 22.03.2024 JP 2024046115; 21.08.2024 JP 2024139464
(71) Applicant: SCREEN Holdings Co., Ltd., Kyoto-shi, Kyoto 602-8585 (JP)
(72) Inventor: YAMAGUCHI, Yu, Kyoto, 602-8585 (JP); INABA, Masaki, Kyoto, 602-8585 (JP); SHIBATA, Shuichi, Kyoto, 602-8585 (JP); LIN, Tsung Ju, Kyoto, 602-8585 (JP)
(74) Representative: Kilian Kilian & Partner mbB

(57) **Abstract**

A substrate processing method includes a processing liquid supplying step of supplying processing liquid to a substrate and a dissolution gas supplying step of dissolving dissolution gas, that has split due to entering a plurality of passages of a splitter, in the processing liquid in a state in which a surface of the splitter including the plurality of passages that are open at the surface is in contact with at least one of the processing liquid in contact with the substrate and the processing liquid away from the substrate.

## Description

### BACKGROUND OF THE INVENTION

### 1. Field of the Invention

The present invention relates to a substrate processing method and a substrate processing apparatus that process substrates. The substrates include a semiconductor wafer, a substrate for a FPD (flat panel display) such as a liquid crystal display and an organic EL (electroluminescence) display, a substrate for an optical disc, a substrate for a magnetic disk, a substrate for a magneto-optical disc, a substrate for a photomask, a ceramic substrate, a substrate for a solar cell, and the like.

### 2. Description of Related Art

JP 2023-34828A discloses that a substrate is disposed in a processing chamber that is filled with ozone gas and that the substrate is heated in a state in which a liquid film of sulfuric acid is formed on a principal surface of the substrate.

At least one preferred embodiment of the present invention provides a substrate processing method and a substrate processing apparatus that are capable of efficiently dissolving dissolution gas in a processing liquid.

### SUMMARY OF THE INVENTION

A preferred embodiment of the present invention provides a substrate processing method including a processing liquid supplying step of supplying processing liquid to a substrate and a dissolution gas supplying step of dissolving dissolution gas, that has split due to entering a plurality of passages of a splitter, in the processing liquid in a state in which a surface of the splitter including the plurality of passages that are open at the surface is in contact with at least one of the processing liquid in contact with the substrate and the processing liquid away from the substrate.

In the preferred embodiment, at least one of the following features may be added to the substrate processing method.

The dissolution gas supplying step includes a step of causing the dissolution gas that has split to discharge from a contact portion of the surface of the splitter into the processing liquid by causing the dissolution gas to flow in the plurality of passages from a noncontact portion of the surface of the splitter in a state in which the contact portion of the splitter is in contact with at least one of the processing liquid in contact with the substrate and the processing liquid away from the substrate and the noncontact portion of the splitter is away from the substrate.

The dissolution gas supplying step includes a step of filling a gas area that is an area on an opposite side of the processing liquid with respect to the splitter with the dissolution gas.

The substrate processing method further includes a cleaning liquid supplying step of supplying cleaning liquid to the substrate after the processing liquid is supplied to the substrate and a splitter-cleaning step of causing a contact portion of the surface of the splitter to be in contact with the cleaning liquid in contact with the substrate.

The splitter-cleaning step includes a step of causing cleaning gas that has split to discharge from the contact portion into the cleaning liquid by causing the cleaning gas to flow in the plurality of passages from a noncontact portion of the surface of the splitter while causing the contact portion of the surface of the splitter to be in contact with the cleaning liquid in contact with the substrate.

The substrate processing method further includes a splitter-drying step of causing the cleaning gas that has split to discharge from the contact portion by causing the cleaning gas to flow in the plurality of passages from the noncontact portion of the surface of the splitter in a state in which the contact portion of the surface of the splitter is away from the cleaning liquid in contact with the substrate, after the splitter-cleaning step.

The dissolution gas supplying step includes a step of dissolving the dissolution gas, that has split due to entering the plurality of passages of the splitter, in the processing liquid in a state in which the surface of the splitter is in contact with the processing liquid in a tank, and the processing liquid supplying step includes a step of supplying the substrate with the processing liquid supplied from the tank.

The processing liquid supplying step includes a step of increasing gas pressure in the tank to a value at which the processing liquid in the tank is discharged from the tank toward the substrate by supplying inert gas into the tank after the dissolution gas has dissolved in the processing liquid in the tank.

The splitter is a porous body.

Another preferred embodiment of the present invention provides a substrate processing apparatus including a processing liquid nozzle that supplies processing liquid to a substrate, a splitter including a plurality of passages that are open at a surface of the splitter, a dissolution gas piping that discharge dissolution gas to the plurality of passages of the splitter and a dissolution gas supplying portion that supplies the dissolution gas to the dissolution gas piping, wherein the dissolution gas supplying portion supplies the dissolution gas to the dissolution gas piping in a state in which a surface of the splitter including the plurality of passages that are open at the surface is in contact with at least one of the processing liquid in contact with the substrate and the processing liquid away from the substrate. The dissolution gas supplying portion may be a dissolution gas generator that generates dissolution gas that is to be supplied to the dissolution gas piping, or may be a fluidic device that comes into contact with dissolution gas that is to be supplied to a dissolution gas piping, and may include at least either one of the dissolution gas generator and the fluidic device. The fluidic device may include at least one among a piping, a valve, a joint, and a tank, or may include a device other than these devices. At least one of the above-described features regarding the substrate processing method may be added to the substrate processing apparatus.

### BRIEF DESCRIPTION OF THE DRAWINGS

FIG. 1A is a schematic plan view showing a layout of a substrate processing apparatus according to a preferred embodiment of the present invention.
FIG. 1B is a schematic side view of the substrate processing apparatus.
FIG. 2 is a schematic view of an interior of a processing unit when viewed horizontally.
FIG. 3 is a schematic view of an interior of a processing unit when viewed horizontally.
FIG. 4 is a schematic view in which a portion of the processing unit is enlarged.
FIG. 5 is a schematic view showing a first example of a splitter disposed in a tank.
FIG. 6 is a schematic view showing a second example of the splitter disposed in the tank.
FIG. 7 is a schematic view showing a state of supplying sulfuric acid in the tank to a substrate.
FIG. 8 is a schematic view for describing a phenomenon predicted to occur when dissolution gas is supplied to the splitter in a state in which the splitter is in contact with a processing liquid.
FIG. 9 is a flow chart for describing an example of processing of a substrate performed by the substrate processing apparatus.
FIG. 10A, FIG. 10B and FIG. 10C are schematic views for describing the example of processing of the substrate performed by the substrate processing apparatus.
FIG. 10D, FIG. 10E and FIG. 10F are schematic views for describing the example of processing of the substrate performed by the substrate processing apparatus.
FIG. 10G, FIG. 10H and FIG. 10I are schematic views for describing the example of processing of the substrate performed by the substrate processing apparatus.
FIG. 10J, FIG. 10K and FIG. 10L are schematic views for describing the example of processing of the substrate performed by the substrate processing apparatus.
FIG. 10M and FIG. 10N are schematic views for describing the example of processing of the substrate performed by the substrate processing apparatus.
FIG. 11 is a schematic view showing another example of a shield member.
FIG. 12 is a schematic view showing another example of a chamber.
FIG. 13 is a schematic view showing another example of the chamber.

### DETAILED DESCRIPTION OF PREFERRED EMBODIMENTS

Preferred embodiments of the present invention will be explained in detail with reference to the accompanying drawings.

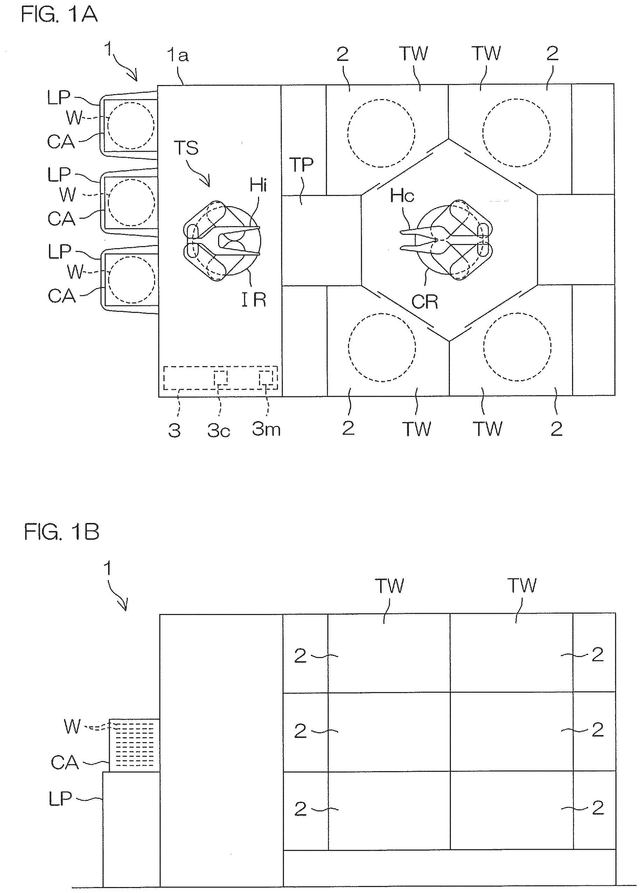

FIG. 1A is a schematic plan view showing a layout of a substrate processing apparatus 1 according to a preferred embodiment of the present invention. FIG. 1B is a schematic side view of the substrate processing apparatus 1.

As shown in FIG, 1A, the substrate processing apparatus 1 is a single substrate processing type apparatus that processes disk-shaped substrates W such as semiconductor wafers one by one. The substrate processing apparatus 1 includes a load port LP that holds a carrier CA housing a plurality of substrates W such as a FOUP (front-opening unified pod), a plurality of processing units 2 that process the substrates W transferred from the carrier CA on the load port LP with processing fluid such as processing liquid or processing gas, a transfer system TS that transfers the substrates W between the carrier CA on the load port LP and the plurality of processing units 2, an outer wall 1a that forms a sealed space housing the plurality of processing units 2 and the transfer system TS, and a controller 3 that controls the substrate processing apparatus 1.

The plurality of processing units 2 form a plurality of towers TW. FIG. 1A shows an example where four towers TW are formed. As shown in FIG. 1B, a plurality of processing units 2 included in a single tower TW are stacked vertically. As shown in FIG. 1A, the plurality of towers TW form two rows extending in the depth direction (the left-right direction of the paper in FIG. 1A) of the substrate processing apparatus 1 in a plan view. The two rows face each other across a transfer path TP in a plan view.

The transfer system TS includes an indexer robot IR and a center robot CR. The indexer robot IR transfers the substrate W between the carrier CA on the load port LP and the center robot CR. The center robot CR transfers the substrate W between the plurality of processing units 2. The indexer robot IR is disposed between the load port LP and the center robot CR, in a plan view. The center robot CR is disposed in the transfer path TP.

The indexer robot IR includes one or more hands Hi that support the substrates W horizontally. The hand Hi is movable in parallel in both the horizontal direction and the vertical direction. The hand Hi is rotatable around a vertical line. The hand Hi can carry in and carry out the substrate W to and from the carrier CA on any of the load ports LP, and can receive and transfer the substrate W from and to the center robot CR.

The center robot CR includes one or more hands Hc that support the substrates W horizontally. The hand Hc is movable in parallel in both the horizontal direction and the vertical direction. The hand Hc is rotatable around a vertical line. The hand Hc can receive and transfer the substrate W from and to the indexer robot IR, and carry in and carry out the substrate W to and from any of the processing units 2.

The controller 3 controls electrical devices and electronic devices provided in the substrate processing apparatus 1. The controller 3 includes at least one computer capable of communicating with each other. The computer includes a CPU (Central Processing Unit) 3c that performs processing of information such as execution of a program and a memory 3m that stores information such as a program to be executed by the CPU 3c. The controller 3 controls the substrate processing apparatus 1 to carry out transfer and processing of the substrate W described below. In other words, the controller 3 is programmed to carry out transfer and processing of the substrate W described below.

Next, a processing unit 2 will be described.

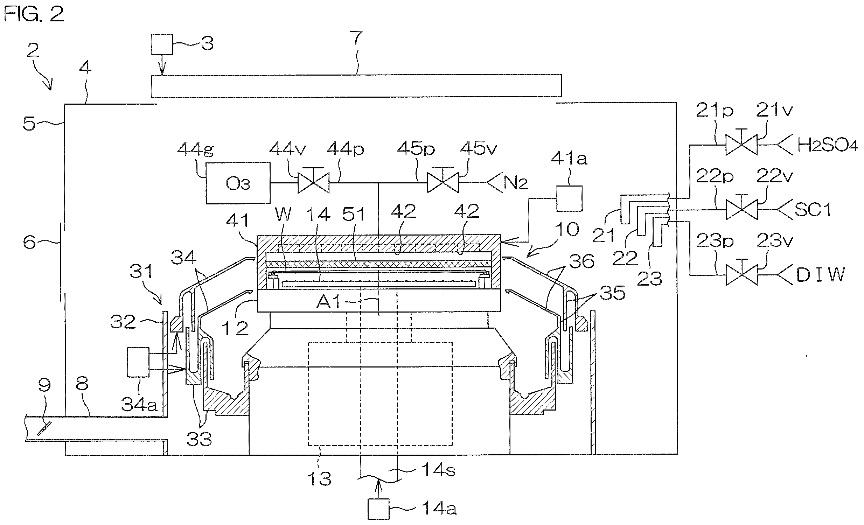

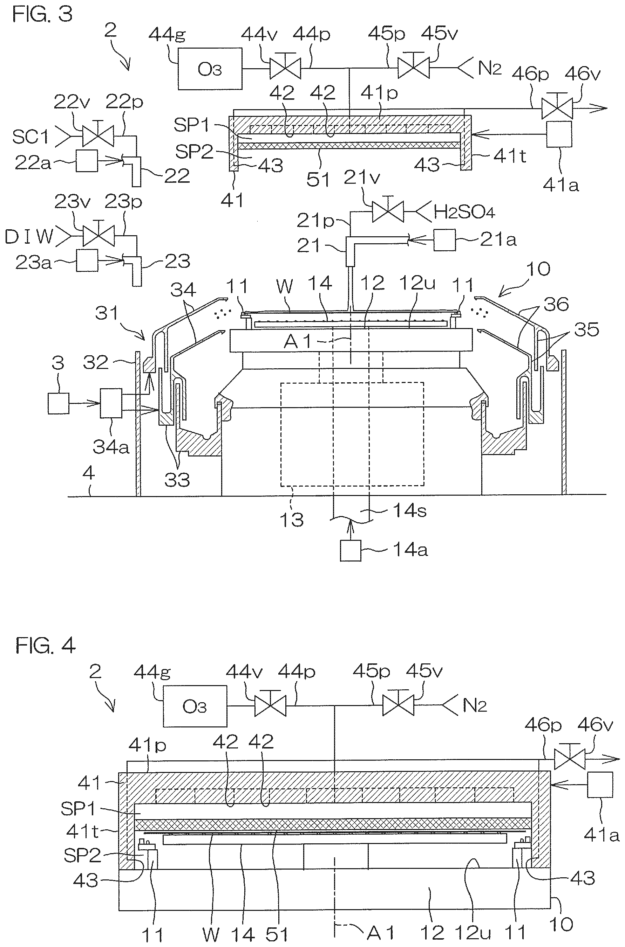

FIG. 2 and FIG. 3 are schematic views of an interior of the processing unit 2 when viewed horizontally. FIG. 2 shows a state where a shield member 41 is disposed at a lower position and the substrate W is supported by a plurality of chuck pins 11. FIG. 3 shows a state where the shield member 41 is disposed at a upper position and the substrate W is supported by the plurality of chuck pins 11. As shown in FIG. 2, the processing unit 2 includes a chamber 4 that houses the substrate W and a spin chuck 10 that rotates one substrate W around a vertical rotational axis A1 passing through the central portion of the substrate W while holding the substrate W horizontally in the chamber 4.

The chamber 4 includes a box-shaped partition 5 provided with a passing port through which the substrate W passes, and a door 6 that opens and closes the passing port. An FFU 7 (fan filter unit) is disposed on an air outlet provided in the upper portion of the partition 5. The FFU 7 constantly supplies clean air (air that has been filtered by a filter) from the air outlet to the chamber 4. The gas in the chamber 4 is discharged from the chamber 4 through a discharged gas duct 8 connected to the bottom portion of a processing cup 31. Thereby, a downflow of clean air is constantly formed inside the chamber 4. The flow rate of discharged gas to be discharged into the discharged gas duct 8 is changed according to the opening degree of a discharged gas valve 9 located in the discharged gas duct 8.

The spin chuck 10 includes a disk-shaped spin base 12 horizontally held, a plurality of chuck pins 11 that hold the substrate W horizontally above the spin base 12, and a spin motor 13 that rotates the spin base 12 and the plurality of chuck pins 11 around the rotational axis A1. The spin chuck 10 is not limited to a gripping-type chuck that contacts the plurality of chuck pins 11 with the end surface of substrate W, and may be a vacuum-type chuck that holds the substrate W horizontally by adsorbing the rear surface (lower surface) of the substrate W, which is a non-device forming surface, onto the upper surface 12u of the spin base 12. When the spin chuck 10 is the gripping-type chuck, the plurality of chuck pins 11 correspond to a substrate holder. When the spin chuck 10 is the vacuum-type chuck, the spin base 12 corresponds to the substrate holder.

The processing unit 2 includes a tubular processing cup 31 that receives processing liquid splashed from the substrate W. The processing cup 31 includes a plurality of guards 34 that receive processing liquid discharged outward from the substrate W held by the spin chuck 10, a plurality of cups 33 that receive the processing liquid guided downward by the plurality of guards 34, and a tubular outer wall 32 surrounding the plurality of guards 34 and the plurality of cups 33. FIG. 2 shows an example where two guards 34 and two cups 33 are provided and the outer cup 33 is integral with the inner guard 34.

The guard 34 includes a cylindrical portion 35 surrounding the spin chuck 10, and an annulus-shaped ceiling portion 36 extending upward obliquely from the upper end portion of the cylindrical portion 35 toward the rotational axis A1. The plurality of ceiling portions 36 overlap each other vertically, and the plurality of cylindrical portions 35 are disposed in a concentric manner. The annulus-shaped upper end of the ceiling portion 36 corresponds to the upper end of the guard 34 surrounding the substrate W and the spin base 12 in a plan view. The plurality of cups 33 are disposed under the plurality of cylindrical portions 35, respectively. The cup 33 forms an annular groove that receives processing liquid guided downward by the guard 34.

The processing unit 2 includes a raising/lowering actuator 34a that individually raises and lowers the plurality of guards 34. The raising/lowering actuator 34a positions the guard 34 at any position within a range from an upper position to a lower position. FIG. 2 shows a state where the outer guard 34 is disposed at the upper position and the inner guard 34 is disposed at the lower position. The upper position is a position where the upper end of the guard 34 is disposed above a holding position where the substrate W held by the spin chuck 10 is positioned. The lower position is a position where the upper end of the guard 34 is disposed below the holding position.

The actuator is a device that converts driving energy, which represents electrical, fluid, magnetic, thermal or chemical energy, to mechanical work, that is, motion of a tangible object. The actuator includes an electric motor (rotary motor), linear motor, air cylinder and other devices. If the motion of the actuator is different from the motion of the object, a motion converter may be provided to convert the motion of the actuator into linear motion or rotation. For example, if the actuator is an electric motor and the object is to be moved in a linear motion, a motion converter, such as a ball screw and ball nut, may convert the rotation of the electric motor into linear motion.

The processing unit 2 includes a plurality of nozzles that discharge processing fluid such as processing liquid or processing gas toward the substrate W positioned above the spin chuck 10. The plurality of nozzles includes a first chemical liquid nozzle 21 that discharges first chemical liquid toward the upper surface of the substrate W positioned above the spin chuck 10, a second chemical liquid nozzle 22 that discharges second chemical liquid toward the upper surface of the substrate W positioned above the spin chuck 10, and a rinse liquid nozzle 23 that discharges rinse liquid toward the upper surface of the substrate W positioned above the spin chuck 10. FIG. 2 shows an example where the first chemical liquid is sulfuric acid (H₂SO₄), the second chemical liquid is SC1, and the rinse liquid is pure water (DIW).

The first chemical liquid nozzle 21 is connected to a first chemical liquid piping 21p that guides the first chemical liquid. When a first chemical liquid valve 21v attached to the first chemical liquid piping 21p is opened, an outlet of the first chemical liquid nozzle 21 continuously discharges the first chemical liquid downward. Similarly, the second chemical liquid nozzle 22 is connected to a second chemical liquid piping 22p that guides the second chemical liquid. When a second chemical liquid valve 22v attached to the second chemical liquid piping 22p is opened, an outlet of the second chemical liquid nozzle 22 continuously discharges the second chemical liquid downward.

The first chemical liquid may be a liquid containing at least one of sulfuric acid, nitric acid, hydrochloric acid, hydrofluoric acid, phosphoric acid, acetic acid, ammonia water, hydrogen peroxide water, organic acid (for example, citric acid, oxalic acid, etc.), organic alkali (for example, TMAH: tetramethylammonium hydroxide, etc.), surfactant, and corrosion inhibitor, or may be a liquid other than this. The same applies to the second chemical liquid. The first chemical liquid may be a chemical liquid that has the same composition as the second chemical liquid and differs from the second chemical liquid in at least one of concentration and temperature.

Although not shown, the first chemical liquid valve 21v includes a valve body provided with an annular valve seat through which chemical liquid passes, a valve element that can move with respect to the valve seat, and an actuator that moves the valve element between a closed position where the valve element contacts the valve seat and an open position where the valve element is away from the valve seat. The same applies to other valves. The actuator may be a pneumatic actuator or an electric actuator, or may be an actuator other than these. The controller 3 opens and closes the first chemical liquid valve 21v and the like by controlling the actuator.

The rinse liquid nozzle 23 is connected to a rinse liquid piping 23p that guides the rinse liquid. When a rinse liquid valve 23v attached to the rinse liquid piping 23p is opened, an outlet of the rinse liquid nozzle 23 continuously discharges the rinse liquid downward. The rinse liquid may be any of pure water (DIW (Deionized Water) ), carbonated water, electrolyzed ionized water, hydrogen water, ozone water, and hydrochloric acid solution having a dilution concentration (for example, about 10 to 100 ppm), or may be a liquid other than these.

The first chemical liquid nozzle 21 may be a scan nozzle that can move a collision position of the chemical liquid with respect to the substrate W within the upper surface of the substrate W or may be a fixed nozzle that cannot move the collision position of the processing liquid with respect to the substrate W. The same applies to other nozzles. FIG. 3 shows an example where the first chemical liquid nozzle 21, the second chemical liquid nozzle 22, and the rinse liquid nozzle 23 are scan nozzles.

As shown in FIG. 3, the first chemical liquid nozzle 21 is connected to a first nozzle actuator 21a that moves the first chemical liquid nozzle 21 in at least one of the vertical and horizontal directions. The second chemical liquid nozzle 22 is connected to a second nozzle actuator 22a that moves the second chemical liquid nozzle 22 in at least one of the vertical and horizontal directions. The rinse liquid nozzle 23 is connected to a third nozzle actuator 23a that moves the rinse liquid nozzle 23 in at least one of the vertical and horizontal directions.

The first nozzle actuator 21a moves the first chemical liquid nozzle 21 horizontally between a processing position at which the chemical liquid discharged from the first chemical liquid nozzle 21 is supplied to the upper surface of the substrate W and a standby position at which the first chemical liquid nozzle 21 is positioned around the processing cup 31 in a plan view. The same applies to the second nozzle actuator 22a and the third nozzle actuator 23a. FIG. 3 shows a state where the first chemical liquid nozzle 21 is disposed at the processing position.

The processing unit 2 includes a hot plate 14 that is an example of a heater that heats the substrate W positioned above the spin chuck 10. The hot plate 14 is disposed between the substrate W and the spin base 12. The hot plate 14 includes a heating element (not shown) that generates joule heat due to energization and an outer case that houses the heating element. The heating element and the outer case are disposed under the substrate W. The heating element is connected to a wiring line (not shown) that supplies electric power to the heating element. The temperature of the heating element is changed by the controller 3. When the controller 3 causes the heating element to generate heat, the entirety of the substrate W is evenly heated.

The outer case of the hot plate 14 includes a disk-shaped base portion disposed under the substrate W and a plurality of hemispherical protrusion portions that protrude upward from an upper surface of the base portion. The upper surface of the base portion is parallel to the lower surface of the substrate W, and has an outer diameter smaller than a diameter of the substrate W. The plurality of protrusion portions come into contact with the lower surface of the substrate W at a position separated upward from the upper surface of the base portion. The plurality of protrusion portions are disposed at a plurality of positions within the upper surface of the base portion so that the substrate W is horizontally supported. The substrate W is horizontally supported in a state in which the lower surface of the substrate W is separated upward from the upper surface of the base portion.

The hot plate 14 is horizontally supported by a support shaft 14s that extends downward from a central portion of the hot plate 14. The plurality of chuck pins 11 are disposed around the hot plate 14. A center line of the hot plate 14 is disposed on the rotational axis A1 of the substrate W. The hot plate 14 does not rotate even when the spin chuck 10 rotates. An outer diameter of the hot plate 14 is smaller than the diameter of the substrate W.

The hot plate 14 is movable in parallel vertically with respect to the spin base 12. The hot plate 14 is connected to a raising/lowering actuator 14a via the support shaft 14s. The raising/lowering actuator 14a vertically raises and lowers the hot plate 14 between the upper position (position shown in FIG. 4) and the lower position (position shown in FIG. 2 and FIG. 3). The upper position is a contact position at which the hot plate 14 comes into contact with the lower surface of the substrate W. The lower position is a proximal position at which the hot plate 14 is disposed between the lower surface of the substrate W and the upper surface of the spin base 12 in a state in which the hot plate 14 is away from the substrate W.

The hot plate 14 is an example of a substrate holder. The raising/lowering actuator 14a brings the hot plate 14 into a stationary state at an arbitrary position within the range from the upper position to the lower position. The substrate W is supported by the chuck pins 11, and, when the hot plate 14 is raised to the upper position in a state in which the holding of the substrate W has been released, the substrate W is lifted by the hot plate 14, and is separated upward from the chuck pins 11. When the hot plate 14 is lowered to the lower position in this state, the substrate W on the hot plate 14 is placed on the chuck pins 11, and the hot plate 14 is separated downward from the substrate W.

The processing unit 2 includes the shield member 41 disposed above the spin chuck 10. The shield member 41 is disposed in the chamber 4. The shield member 41 includes a disk-shaped disk portion 41p that is horizontally held and a cylindrical portion 41t that extends downward from an outer peripheral portion of the disk portion 41p. The disk portion 41p is referred to also as a shield plate. A lower surface of the disk portion 41p corresponds to a lower surface of the shield member 41. The center of the disk portion 41p is disposed on the rotational axis A1 of the substrate W. An inner diameter of the cylindrical portion 41t is smaller than an outer diameter of the spin base 12. An outer diameter of the cylindrical portion 41t is smaller than an inner diameter of the upper end of the guard 34.

The shield member 41 is connected to a raising/lowering actuator 41a that moves the shield member 41 in parallel vertically. The raising/lowering actuator 41a brings the shield member 41 into a stationary state at an arbitrary position within the range from the upper position (position shown in FIG. 3) to the lower position (position shown in FIG. 2). The lower position is a proximal position at which the lower surface of the shield member 41 approaches the upper surface of the substrate W up to a height at which a scan nozzle, such as the first chemical liquid nozzle 21, cannot enter a space between the substrate W and the shield member 41. The upper position is a standby position at which the shield member 41 is retreated to a height at which the scan nozzle is capable of entering a space between the shield member 41 and the substrate W.

When the raising/lowering actuator 41a disposes the shield member 41 at the lower position as shown in FIG. 2, a lower end of the cylindrical portion 41t of the shield member 41 is disposed at a position lower than the substrate W held by the spin chuck 10, and the substrate W is surrounded by the cylindrical portion 41t. The same applies to a case in which the substrate W is held by not the spin chuck 10 but the hot plate 14. The chuck pins 11 are disposed inside the cylindrical portion 41t.

When the raising/lowering actuator 41a disposes the shield member 41 at the lower position, a gap between the cylindrical portion 41t and the spin base 12 may be sealed, or does not need to be sealed. In the former case, the cylindrical portion 41t may be directly pressed against the spin base 12, or may be pressed against the spin base 12 via a seal ring made of rubber or resin. FIG. 2 shows an example in which the cylindrical portion 41t is directly pressed against the spin base 12. When the shield member 41 is disposed at the lower position, a space inside the shield member 41 is sealed.

Next, a splitter 51 disposed above the substrate W will be described.

FIG. 4 is a schematic view in which a portion of the processing unit 2 is enlarged. FIG. 4 shows a state in which the shield member 41 is disposed at the lower position and in which the substrate W is supported by the hot plate 14. The processing unit 2 includes the splitter 51 that splits gas, such as dissolution gas, a dissolution gas piping 44p that guides a dissolution gas that is to be supplied to the splitter 51, and an inert gas piping 45p that guides inert gas that is to be supplied to the splitter 51. FIG. 4 shows an example in which the dissolution gas is ozone gas (O₃), and the inert gas is nitrogen gas (N₂). If the dissolution gas is ozone gas, the processing unit 2 includes an ozone generator 44g that generates ozone gas that is to be supplied to the dissolution gas piping 44p. The ozone generator 44g is an example of a dissolution gas supplying portion and a dissolution gas supplying source.

A dissolution gas valve 44v is attached to the dissolution gas piping 44p. An inert gas valve 45v is attached to the inert gas piping 45p. Opening the dissolution gas valve 44v means that the dissolution gas valve 44v is switched to an open state. Closing the dissolution gas valve 44v means that the dissolution gas valve 44v is switched to a closed state. The same applies to the inert gas valve 45v.

The open state of the dissolution gas valve 44v is a state in which dissolution gas in the dissolution gas piping 44p is supplied to the splitter 51. The closed state of the dissolution gas valve 44v is a state in which dissolution gas in the dissolution gas piping 44p is not supplied to the splitter 51. Likewise, the open state of inert gas is a state in which inert gas in the inert gas piping 45p is supplied to the splitter 51. The closed state of inert gas is a state in which inert gas in the inert gas piping 45p is not supplied to the splitter 51.

Ozone gas is supplied to sulfuric acid via the splitter 51 as described below. Sulfuric acid is an example of a processing liquid. The first chemical liquid nozzle 21 (see FIG. 3) is an example of a processing liquid nozzle that discharges a processing liquid toward the substrate W. When ozone gas is dissolved in sulfuric acid, SOM (Sulfuric acid and Ozone Mixture), which is ozone-containing sulfuric acid, is produced. Unless otherwise specified, SOM represents a liquid. Sulfuric acid used to produce SOM is concentrated sulfuric acid (an aqueous solution of sulfuric acid in which the concentration of sulfuric acid is equal to or more than 90%). If there is no obstacle in etching an etching-target object, SOM may be produced by use of an aqueous solution of sulfuric acid having the concentration of the sulfuric acid lower than that of the concentrated sulfuric acid.

The combination of a processing liquid and dissolution gas may exclude sulfuric acid and ozone gas. For example, the combination of a processing liquid and dissolution gas may be any one combination of water and ammonia gas, water and fluorine gas, and hydrogen peroxide water and ammonia gas, or may exclude these combinations. When ammonia gas is dissolved in water, ammonia water is produced. When fluorine gas is dissolved in water, hydrofluoric acid is produced. When ammonia gas is dissolved in hydrogen peroxide water, SC1 that is a mixed liquid of ammonia, hydrogen peroxide, and water is produced.

The splitter 51 is a tangible object including a plurality of passages that are opened at a surface of the splitter 51. The splitter 51 may be a tangible object that can be regarded as a rigid body, or may be a tangible object having flexibility. The splitter 51 may be a tangible object (porous body, sponge, etc.) in which a plurality of irregular passages both ends of each of which are opened at a surface of the splitter 51 are provided, or may be a tangible object (honeycomb structural body, perforated panel, etc.) in which a plurality of passages passing through the splitter 51 in the same direction are provided. If both ends of the passage are opened at the surface of the splitter 51, the passage may be a long passage in which the length of a center line of the passage is longer than the width or diameter (length in a direction perpendicular to the center line of the passage) of the passage, or may be a short passage in which the length of the center line of the passage is equal to or less than the width or diameter of the passage. The cross section of the passage perpendicular to the center line of the passage may be any one of a polygon, a circle, and an ellipse, or may be one other than these shapes. If the cross section of the passage is a circle, the diameter of the passage may be less than 1 mm.

FIG. 4 shows an example in which the splitter 51 is disposed in the shield member 41 and is fixed to the shield member 41. The splitter 51 moves together with the shield member 41. In this example, the splitter 51 is a horizontal disk that has an outer diameter equal to an inner diameter of the cylindrical portion 41t. The splitter 51 divides a space inside the shield member 41, i.e., a space inside the cylindrical portion 41t, into an upper space SP1 above the splitter 51 and a lower space SP2 below the splitter 51. The upper space SP1 is a space between the disk portion 41p and the splitter 51.

In the example of FIG. 4, a plurality of gas outlets 42 through which gas is discharged are opened at a lower surface of the disk portion 41p of the shield member 41, and a plurality of gas inlets 43 through which gas is suctioned are opened at an inner peripheral surface of the cylindrical portion 41t of the shield member 41. The plurality of gas outlets 42 are disposed at a plurality of positions that are mutually different in the distance from the center of the disk portion 41p. The plurality of gas inlets 43 are disposed at a plurality of positions that are away from each other in a circumferential direction of the shield member 41. The plurality of gas inlets 43 are disposed below the splitter 51. The plurality of gas inlets 43 may be disposed at a height equal to that of the substrate W supported by the plurality of chuck pins 11 or the hot plate 14, or may be disposed above or below this substrate W.

The dissolution gas piping 44p and the inert gas piping 45p described above are connected to the gas outlets 42. When the dissolution gas valve 44v is opened, ozone gas is discharged from the plurality of gas outlets 42. Likewise, when the inert gas valve 45v is opened, nitrogen gas is discharged from the plurality of gas outlets 42. The plurality of gas inlets 43 are connected to a discharged gas pipe 46p that transmits a suction force. When a discharged gas valve 46v attached to the discharged gas pipe 46p is opened, gas is discharged from a space inside the plurality of shield member 41 to the gas inlets 43.

When plurality of the gas outlets 42 discharge dissolution gas, such as ozone gas, the dissolution gas diffuses in the upper space SP1 of the shield member 41, and flows from the upper space SP1 to the lower space SP2 via the splitter 51. When the plurality of gas outlets 42 discharge nitrogen gas, the nitrogen gas diffuses and flows in the same way as above. The upper space SP1 of the shield member 41 is an example of a gas area that is filled with gas.

When the plurality of gas outlets 42 discharge dissolution gas in a state where the shield member 41 is disposed at the lower position and a space inside the shield member 41 is sealed, the atmospheric pressure of the upper space SP1 and that of the lower space SP2 rise. When the plurality of gas outlets 42 discharge nitrogen gas, the atmospheric pressure rises in the same way as above. The plurality of gas inlets 43 suction gas in the lower space SP2. Hence, the atmospheric pressure of the upper space SP1 and that of the lower space SP2 fall.

Next, the splitter 51 disposed in a tank 52 will be described.

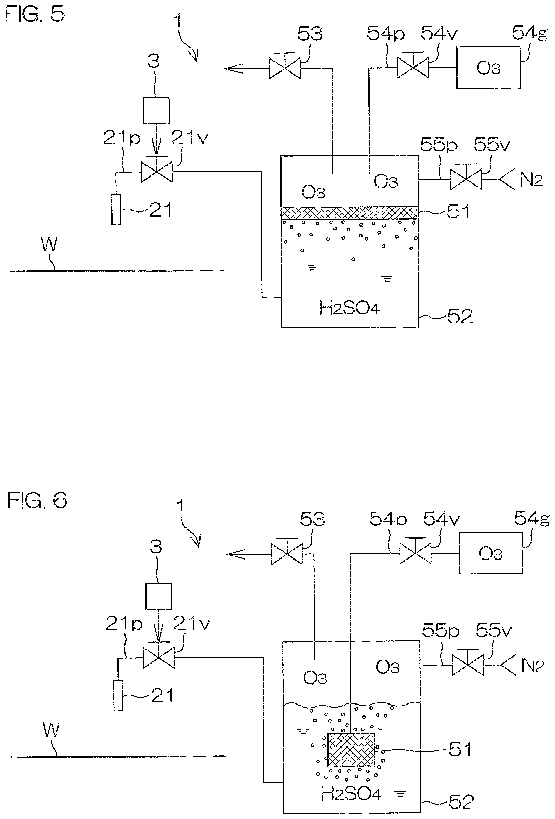

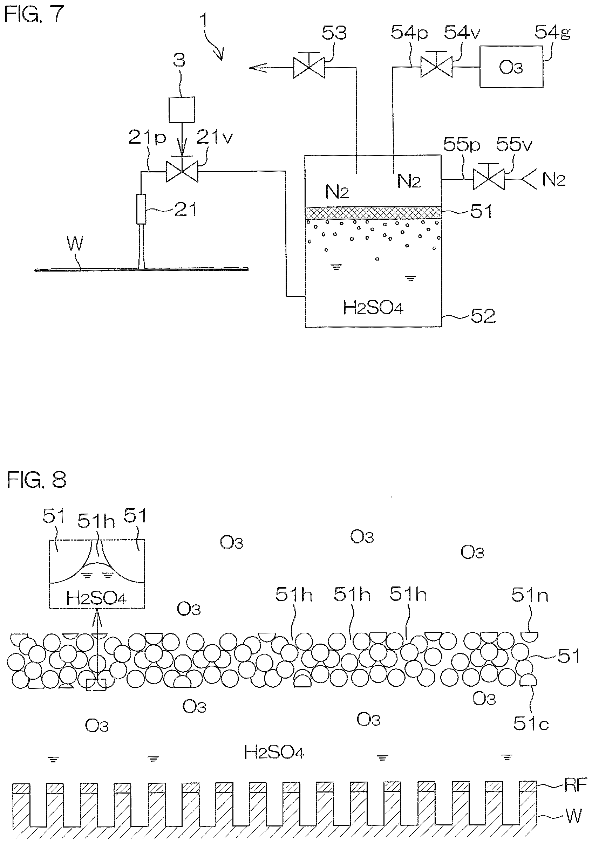

FIG. 5 is a schematic view showing a first example of the splitter 51 disposed in the tank 52. FIG. 6 is a schematic view showing a second example of the splitter 51 disposed in the tank 52. FIG. 7 is a schematic view showing a state of supplying sulfuric acid in the tank 52 to the substrate W.

As shown in FIG. 5 and FIG. 6, the substrate processing apparatus 1 includes the tank 52 that stores sulfuric acid that is an example of the first chemical liquid that is to be supplied to the first chemical liquid nozzle 21 and the splitter 51 disposed in the tank 52. The structure, the quality, etc., of the splitter 51 shown in FIG. 5 and FIG. 6 are the same as the splitter 51 shown in FIG. 2 to FIG. 4 excluding the size and the shape. FIG. 5 shows an example in which the splitter 51 partitions the inside of the tank 52 into two areas, i.e., into a gas area filled with gas and a liquid area filled with sulfuric acid. FIG. 6 shows an example in which the entirety of the splitter 51 is disposed in the sulfuric acid in the tank 52.

In the example of FIG. 5, an upper area of the splitter 51 corresponds to the gas area, and a lower area of the splitter 51 corresponds to the liquid area. The splitter 51 is disposed at a boundary between the gas area and the liquid area. An upper surface of the splitter 51 is in contact with gas in the tank 52, and a lower surface of the splitter 51 is in contact with sulfuric acid in the tank 52. The splitter 51 floats on a surface of the sulfuric acid in the tank 52. When the surface of the sulfuric acid moves vertically in the tank 52, the splitter 51 also moves vertically in the tank 52 in accordance with that movement. Hence, a state in which the splitter 51 is in contact with the surface of the sulfuric acid in the tank 52 is maintained. The splitter 51 may be fixed to the tank 52. In this case, by replenishing the tank 52 with sulfuric acid, a state in which the splitter 51 is in contact with the surface of the sulfuric acid in the tank 52 may be maintained.

In the example of FIG. 6, an upper area of a surface of sulfuric acid is a gas area, and a lower area of the surface of the sulfuric acid is a liquid area. The splitter 51 is disposed at a lower position than the surface of the sulfuric acid in the tank 52. Therefore, the whole area of the surface of the splitter 51 is in contact with the sulfuric acid. The splitter 51 is supported by a dissolution gas piping 54p. Even when the surface of the sulfuric acid moves vertically in the tank 52, a state in which at least a portion of the surface of the splitter 51 is in contact with the sulfuric acid is maintained. A downstream end of the dissolution gas piping 54p is disposed in the splitter 51. Ozone gas flows out from the dissolution gas piping 54p through a hole bored at the downstream end of the dissolution gas piping 54p. Hence, the ozone gas passes through the splitter 51, and is emitted from the surface of the splitter 51 into the sulfuric acid.

As shown in FIG. 5 and FIG. 6, the substrate processing apparatus 1 includes the dissolution gas piping 54p that supplies ozone gas that is an example of dissolution gas into the tank 52 and an inert gas piping 55p that supplies nitrogen gas that is an example of inert gas into the tank 52. When a dissolution gas valve 54v is opened, ozone gas generated by an ozone generator 54g is supplied into the tank 52 via the dissolution gas piping 54p. When an inert gas valve 55v is opened, nitrogen gas is supplied into the tank 52 via the inert gas piping 55p. The dissolution gas valve 54v switches between an open state and a closed state. The inert gas valve 55v switches in the same way as above. In either one of the examples of FIGS. 5 and 6, a downstream end of the inert gas piping 55p is disposed at a higher position than the surface of sulfuric acid in the tank 52.

The substrate processing apparatus 1 includes a pressure control valve 53 that maintains air pressure of the inside of the tank 52 at a value less than a set value by lowering the air pressure of the inside of the tank 52 when the air pressure of the inside of the tank 52 reaches a set value higher than atmospheric air pressure. The pressure control valve 53 includes an annular valve seat through which gas discharged from the tank 52 passes, a valve element that can move with respect to the valve seat, and an electric actuator that changes the cross-sectional area of a flow path between the valve seat and the valve element by moving the valve element with respect to the valve seat (not shown). The pressure control valve 53 further includes a pressure sensor that detects air pressure upstream of the valve seat and a valve controller that maintains a detection value of the pressure sensor at a value less than a set value by moving the valve element to the electric actuator on the basis of the detection value of the pressure sensor. The valve controller maintains the air pressure of the inside of the tank 52 at a value less than a set value designated by the controller 3.

In the example of FIG. 5, when the dissolution gas valve 54v is opened, ozone gas is supplied to a gas area of the tank 52, and the air pressure of the inside of the tank 52 rises to a value less than the set value. Ozone gas in the gas area is supplied to sulfuric acid in the tank 52 through the splitter 51. Hence, the ozone gas comes into contact with the sulfuric acid in the tank 52, and is dissolved in this sulfuric acid. Additionally, the ozone gas forms many air bubbles in the sulfuric acid contained in the tank 52. Hence, the ozone gas is further dissolved in the sulfuric acid contained in the tank 52.

In the example of FIG. 6, when the dissolution gas valve 54v is opened, ozone gas is emitted from the surface of the splitter 51 into the sulfuric acid without passing through the gas area. Hence, the ozone gas comes into contact with the sulfuric acid contained in the tank 52, and is dissolved in this sulfuric acid. Additionally, the ozone gas forms many air bubbles in the sulfuric acid contained in the tank 52. Hence, the ozone gas is further dissolved in the sulfuric acid contained in the tank 52. The air bubbles of the ozone gas are emitted from the surface of the sulfuric acid contained in the tank 52 into the gas area. Hence, the air pressure of the inside of the tank 52 rises to a value less than the set value.

The tank 52 is in a sealed state. An upstream end of the first chemical liquid piping 21p is disposed at a lower position than the surface of the sulfuric acid contained in the tank 52. The sulfuric acid in the tank 52 is supplied to the first chemical liquid nozzle 21 via the first chemical liquid piping 21p. The controller 3 may send the sulfuric acid contained in the tank 52 to the first chemical liquid nozzle 21 by raising the air pressure of the inside of the tank 52. In this case, the controller 3 may raise the air pressure of the inside of the tank 52 by supplying ozone gas or nitrogen gas into the tank 52, or may raise the air pressure of the inside of the tank 52 by supplying ozone gas and nitrogen gas into the tank 52.

FIG. 7 shows an example in which the sulfuric acid contained in the tank 52 is sent to the first chemical liquid nozzle 21 by supplying nitrogen gas into the tank 52. In this case, the controller 3 supplies ozone gas into the tank 52 in a state in which the first chemical liquid valve 21v is closed. Hence, the ozone gas is dissolved in the sulfuric acid. Thereafter, the controller 3 closes the dissolution gas valve 54v, and opens the inert gas valve 55v. Hence, nitrogen gas is supplied from the inert gas valve 55v to the tank 52.

When nitrogen gas is supplied after supplying ozone gas, the ozone gas in the gas area of the tank 52 is replaced with the nitrogen gas while the air pressure of the inside of the tank 52 is being maintained at a value that is higher than atmospheric air pressure and that is lower than a set value. The controller 3 opens the first chemical liquid valve 21v in a state in which the air pressure of the inside of the tank 52 is high. Hence, the sulfuric acid contained in the tank 52 is sent to the first chemical liquid piping 21p by means of the pressure of nitrogen gas, and is discharged from the first chemical liquid nozzle 21. Therefore, it is possible to supply sulfuric acid in which ozone gas has been dissolved from the first chemical liquid nozzle 21 to the substrate W while reducing ozone gas discharged from the first chemical liquid nozzle 21.

Next, a description will be given of a phenomenon predicted to occur when dissolution gas is supplied to the splitter 51 in a state in which the splitter 51 is in contact with a processing liquid.

FIG. 8 is a schematic view for describing this phenomenon. In FIG. 8, an example is shown in which an upper surface of a pattern formed on the upper surface of the substrate W is covered with a resist film RF that is an example of an etching-target object. In this example, the splitter 51 has a porous body. In the example of FIG. 8, the upper surface of the splitter 51 is a noncontact portion 51n that does not come into contact with a processing liquid, and the lower surface of the splitter 51 is a contact portion 51c that comes into contact with a processing liquid. The upper surface and the lower surface of the splitter 51 are portions of the surface of the splitter 51. The contact portion 51c is away from the upper surface of the substrate W.

A plurality of passages 51h of the splitter 51 are opened at the contact portion 51c and at the noncontact portion 51n of the splitter 51. Therefore, when dissolution gas is supplied to the splitter 51, the dissolution gas passes through the inside of the splitter 51, and goes from the surface of the splitter 51 toward the outside of the splitter 51. The dissolution gas is split into a plurality of dissolution-gas lumps by entering the plurality of passages 51h. A single lump of the dissolution-gas may have a spherical or linear shape, or may have a shape other than these shapes.

The pressure of dissolution gas applied to the splitter 51 sends the plurality of dissolution-gas lumps existing in the plurality of passages 51h toward a processing liquid that is in contact with the surface of the splitter 51. When dissolution gas is supplied to the splitter 51 in a state in which the surface of the splitter 51 is in contact with the processing liquid, the plurality of dissolution-gas lumps are emitted from the plurality of passages 51h into the processing liquid. Hence, many dissolution-gas air bubbles are generated in the processing liquid.

The plurality of dissolution-gas lumps come into contact with the processing liquid at the surface of the splitter 51. If the processing liquid enters the plurality of passages 51h from the surface of the splitter 51, the plurality of dissolution-gas lumps come into contact with the processing liquid in the splitter 51. Dissolution-gas air bubbles generated in the processing liquid also come into contact with the processing liquid. At least one of these contacts causes the dissolution gas to be dissolved in the processing liquid. If the dissolution gas includes a substance that reacts with the processing liquid, the dissolution gas reacts with the processing liquid.

When the dissolution gas is split, the surface area of the dissolution gas becomes larger than in a case in which the dissolution gas is not split, if the volume of the dissolution gas is the same. When the dissolution gas is not supplied to the splitter 51, i.e., when the air pressure in the plurality of passages 51h does not rise, a surface of a hemispherical processing liquid is formed at the end of the plurality of passages 51h or formed in the plurality of passages 51h by means of surface tension of the processing liquid as shown in an enlarged manner within a frame defined by an alternate long and two short dashed line in FIG. 8. Hence, a contact area between the processing liquid and the dissolution gas increases. An increase in the contact area between the processing liquid and the dissolution gas facilitates the dissolution of the dissolution gas in the processing liquid. This increase will facilitate a reaction between the dissolution gas and the processing liquid if the dissolution gas includes a substance that reacts with the processing liquid.

If the combination of the processing liquid and dissolution gas is a combination of sulfuric acid and ozone gas, SOM that is ozone-containing sulfuric acid is produced when the ozone gas is dissolved in the sulfuric acid. The sulfuric acid contained in SOM is dissociated into hydrogen ions and hydrogensulfate ions. SOM includes not only sulfuric acid but also ozone molecules. Hydrogensulfate ions and ozone molecules in SOM generate water and peroxodisulfate ions as a result of reacting together. When SOM is heated, thermal energy is given to peroxodisulfate ions included in SOM. Hence, peroxodisulfate ions are changed into sulfate ion radicals that are referred to also as sulfuric acid radicals. When ozone gas is brought into contact with sulfuric acid via the splitter 51 while heating the sulfuric acid, the concentration of active species included in SOM, such as sulfate ion radicals, increases. This makes it possible to efficiently remove an etching-target object, such as resist film RF, by means of SOM.

Next, an example of processing of the substrate W will be described.

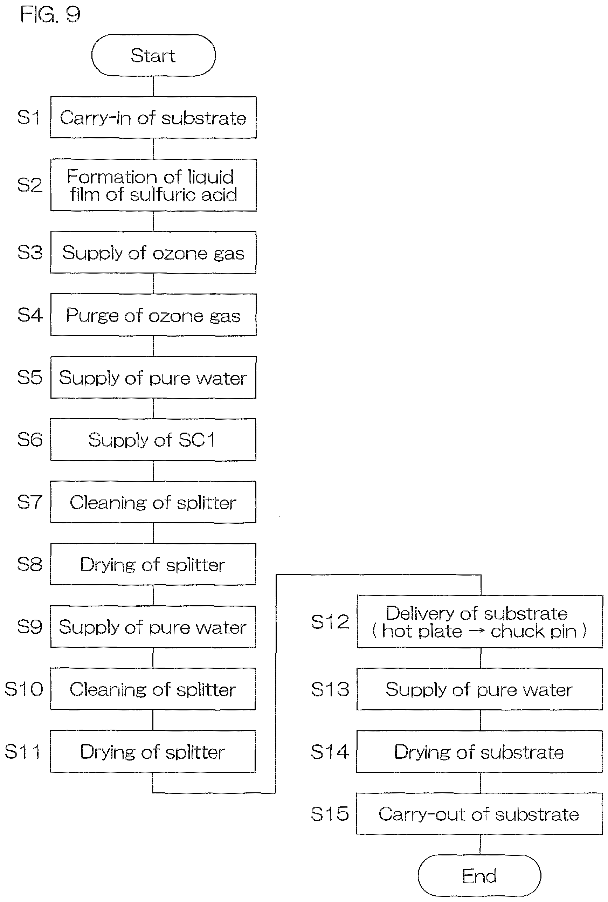

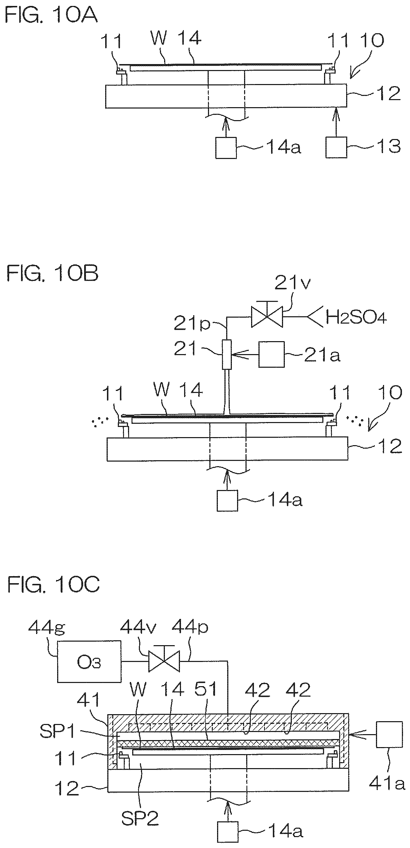

FIG. 9 is a flow chart for describing an example of processing of the substrate W performed by the substrate processing apparatus 1. FIG. 10A to FIG. 10N are schematic views for describing the example. A description will be hereinafter given of an etching process of removing a resist film RF, which is an example of an etching-target object, from the upper surface of the substrate W shown in FIG. 8. Reference is made to FIG. 9 and FIG. 3 as below. Reference is appropriately made to FIG. 10A to FIG. 10N.

When the substrate W is processed by the substrate processing apparatus 1, a carrying-in step (step S1 of FIG. 9) is performed in which the substrate W is carried into the chamber 4.

Specifically, all the guards 34 are positioned at the lower position, all the scan nozzles are positioned at the standby position, the shield member 41 is positioned at the upper position, and the hot plate 14 is positioned at the lower position, and, in a state in which the plurality of chuck pins 11 are opened, the center robot CR (see FIG. 1A) causes the hand Hc to enter the inside of the chamber 4 while supporting the substrate W with the hand Hc. In a state in which the plurality of chuck pins 11 are opened, the center robot CR places the substrate W, which is positioned on the hand Hc, on the plurality of chuck pins 11 such that the surface of the substrate W faces upward. Thereafter, the center robot CR causes the hand Hc to retreat from the inside of the chamber 4. After the substrate W is placed on the plurality of chuck pins 11, the raising/lowering actuator 14a moves the hot plate 14 from the lower position to the upper position. Hence, the substrate W is lifted by the hot plate 14, and is separated upward from the plurality of chuck pins 11 as shown in FIG. 10A.

After the substrate W is supported by the hot plate 14, a first chemical liquid supplying step is performed in which SOM that is an example of a first chemical liquid is supplied to the upper surface of the substrate W.

The first chemical liquid supplying step includes a first liquid-film forming step (step S2 of FIG. 9) of forming a liquid film of sulfuric acid on the upper surface of the substrate W and a first gas supplying step (step S3 of FIG. 9) of supplying ozone gas to the splitter 51 that is in contact with sulfuric acid on the substrate W while heating the sulfuric acid on the substrate W.

When the first liquid-film forming step is performed, the first nozzle actuator 21a moves the first chemical liquid nozzle 21 from the standby position to the processing position in a state in which the shield member 41 is positioned at the upper position. Thereafter, the first chemical liquid valve 21v is opened. Hence, the first chemical liquid nozzle 21 starts discharging the sulfuric acid as shown in FIG. 10B. Before the sulfuric acid starts being discharged, the raising/lowering actuator 34a raises at least one of the guards 34 from the lower position to the upper position.

The sulfuric acid discharged from the first chemical liquid nozzle 21 collides with the upper surface of the substrate W supported by the hot plate 14, and then spreads along the upper surface of the substrate W. Hence, the whole area of the upper surface of the substrate W supported by the hot plate 14 is covered with a liquid film of the sulfuric acid. Thereafter, the first chemical liquid valve 21v is closed, and the first chemical liquid nozzle 21 stops discharging the sulfuric acid. The first nozzle actuator 21a moves the first chemical liquid nozzle 21 from the processing position to the standby position in a state in which the first chemical liquid nozzle 21 does not discharge the sulfuric acid.

When the first gas supplying step is performed, the raising/lowering actuator 41a moves the shield member 41 from the upper position to the lower position in a state in which the whole area of the upper surface of the substrate W has been covered with the liquid film of the sulfuric acid. Hence, a gap between the cylindrical portion 41t of the shield member 41 and the spin base 12 of the spin chuck 10 is closed, and a space inside the shield member 41 (space inside the cylindrical portion 41t) is sealed. When the shield member 41 is disposed at the lower position, the distance from the lower surface of the splitter 51 to the upper surface of the substrate W is reduced from a value larger than the thickness of the liquid film of the sulfuric acid to a value smaller than this thickness. Hence, the lower surface of the splitter 51 fixed to the shield member 41 comes into contact with the liquid film of the sulfuric acid on the substrate W.

The hot plate 14 heats the substrate W while supporting the substrate W. Hence, the sulfuric acid being in contact with the substrate W is heated. When the hot plate 14 heats the substrate W, the temperature of the sulfuric acid on the substrate W is raised to a value that is higher than room temperature (e.g., 20 to 30°C) and that is lower than the boiling point of the sulfuric acid. The temperature of the sulfuric acid while the hot plate 14 is heating the substrate W may be equal to or more than 100°C or 200°C, or may be less than 100°C or 200°C. The hot plate 14 may start heat generation at the same time as the sulfuric acid is supplied to the substrate W, or may start heat generation before or after the sulfuric acid is supplied to the substrate W.

As shown in FIG. 10C, a space inside the shield member 41 is sealed, and the lower surface of the splitter 51 is in contact with the liquid film of the sulfuric acid on the substrate W, and the dissolution gas valve 44v is opened in a state in which the hot plate 14 is heating the substrate W. Hence, the plurality of gas outlets 42 of the shield member 41 start discharging ozone gas. The ozone gas discharged from the plurality of gas outlets 42 fills the upper space SP1 of the shield member 41, and moves from the upper space SP1 of the shield member 41 to the lower space SP2 of the shield member 41 via the splitter 51. Hence, the ozone gas is dissolved into the liquid film of the sulfuric acid on the substrate W, and the liquid film of the sulfuric acid on the substrate W is changed into a liquid film of SOM. SOM reacts with a resist film RF (see FIG. 8) formed on the upper surface of the substrate W. Hence, the resist film RF is removed from the substrate W.

After SOM is supplied to the whole area of the upper surface of the substrate W, a purge step (step S4 of FIG. 9) is performed in which the space inside the shield member 41 is filled with inert gas.

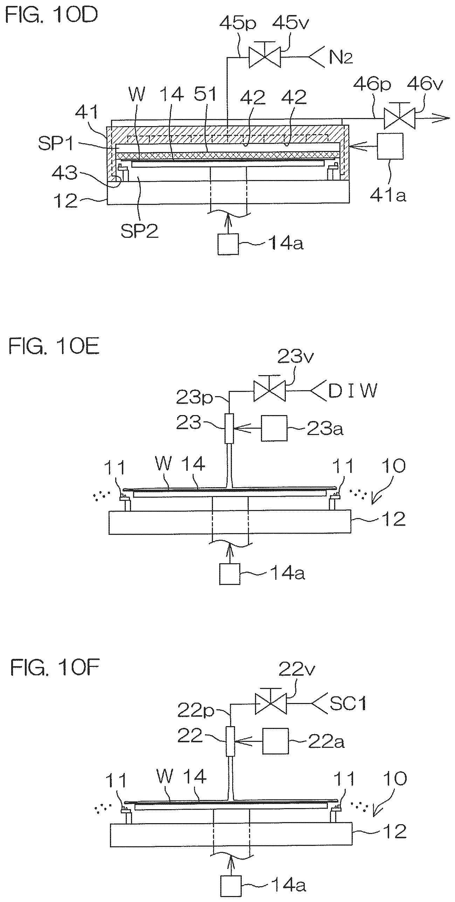

Specifically, when a predetermined period of time elapses after the plurality of gas outlets 42 of the shield member 41 start discharging ozone gas, the dissolution gas valve 44v is closed, and the plurality of gas outlets 42 of the shield member 41 stop discharging the ozone gas. Thereafter, the inert gas valve 45v is opened in a state in which the shield member 41 is positioned at the lower position as shown in FIG. 10D. If the discharged gas valve 46v is in a closed state, the discharged gas valve 46v is opened at the same time as the inert gas valve 45v is opened or after the inert gas valve 45v is opened. Hence, ozone gas that remains in the space inside the shield member 41 is replaced with inert gas.

After the space inside the shield member 41 is filled with the inert gas, a first rinse liquid supplying step (step S5 of FIG. 9) is performed in which pure water, which is an example of a rinse liquid, is supplied to the upper surface of the substrate W.

Specifically, the raising/lowering actuator 41a moves the shield member 41 from the lower position to the upper position. Hence, the lower surface of the splitter 51 is separated upward from SOM existing on the substrate W. Thereafter, the third nozzle actuator 23a moves the rinse liquid nozzle 23 from the standby position to the processing position in a state in which the substrate W is supported by the hot plate 14 and in which the shield member 41 is positioned at the upper position. Thereafter, the rinse liquid valve 23v is opened. Hence, the rinse liquid nozzle 23 starts discharging pure water as shown in FIG. 10E. The raising/lowering actuator 34a may, by vertically moving at least one of the guards 34 before the pure water starts being discharged, perform switching between the guards 34 each of which catches a liquid discharged from the substrate W. This is performed in the same way as in a second chemical liquid supplying step, a second rinse liquid supplying step, and a third rinse liquid supplying step each of which will be described below.

The pure water discharged from the rinse liquid nozzle 23 collides with the upper surface of the substrate W supported by the hot plate 14, and the spreads along the upper surface of the substrate W. Hence, SOM on the substrate W is replaced with the pure water, and the whole area of the upper surface of the substrate W supported by the hot plate 14 is covered with a liquid film of the pure water. Thereafter, the rinse liquid valve 23v is closed, and the rinse liquid nozzle 23 stops discharging the pure water. The third nozzle actuator 23a moves the rinse liquid nozzle 23 from the processing position to the standby position in a state in which the rinse liquid nozzle 23 does not discharge the pure water.

The hot plate 14 stops heat generation before SOM on the substrate W is replaced with the pure water. The hot plate 14 may stop heat generation at the same time as the plurality of gas outlets 42 of the shield member 41 stop discharging the ozone gas, or may stop heat generation before or after the plurality of gas outlets 42 of the shield member 41 stop discharging the ozone gas. The hot plate 14 may stop heat generation after SOM on the substrate W is replaced with the pure water. The substrate W is delivered from the hot plate 14 to the plurality of chuck pins 11 as described below. The hot plate 14 may stop heat generation at the same time as the substrate W is delivered to the plurality of chuck pins 11, or may stop heat generation before or after the substrate W is delivered to the plurality of chuck pins 11.

After SOM on the substrate W is replaced with the pure water, the second chemical liquid supplying step (step S6 of FIG. 9) is performed in which SC1 that is an example of the second chemical liquid is supplied to the upper surface of the substrate W.

Specifically, the second nozzle actuator 22a moves the second chemical liquid nozzle 22 from the standby position to the processing position in a state in which the substrate W is supported by the hot plate 14 and in which the shield member 41 is positioned at the upper position. Thereafter, the second chemical liquid valve 22v is opened. Hence, the second chemical liquid nozzle 22 starts discharging SC1 as shown in FIG. 10F. SC1 discharged from the second chemical liquid nozzle 22 collides with the upper surface of the substrate W supported by the hot plate 14, and then spreads along the upper surface of the substrate W. Hence, the pure water on the substrate W is replaced with SC1, and the whole area of the upper surface of the substrate W supported by the hot plate 14 is covered with a liquid film of SC1. Thereafter, the second chemical liquid valve 22v is closed, and the second chemical liquid nozzle 22 stops discharging SC1. The second nozzle actuator 22a moves the second chemical liquid nozzle 22 from the processing position to the standby position in a state in which the second chemical liquid nozzle 22 does not discharge SC1.

The pure water on the substrate W is replaced with SC1, and then a first splitter-cleaning step (step S7 of FIG. 9) is performed in which the splitter 51 is cleaned with both SC1 that is an example of a cleaning liquid and nitrogen gas that is an example of cleaning gas.

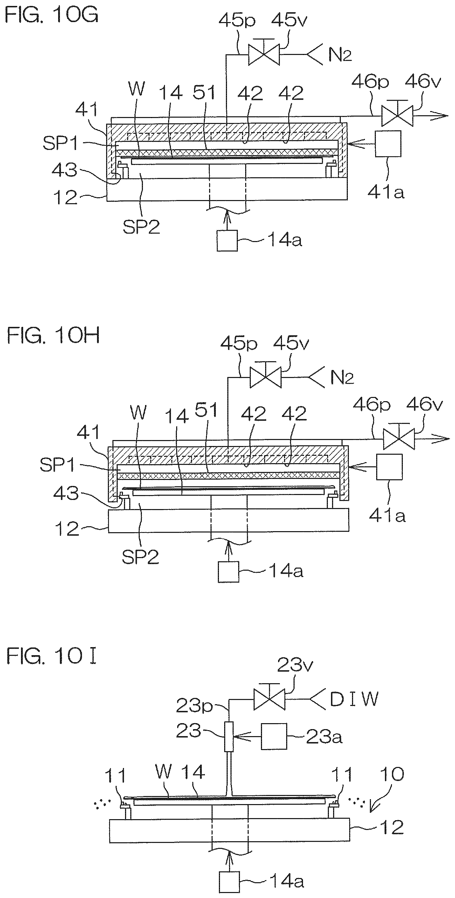

Specifically, the raising/lowering actuator 41a moves the shield member 41 from the upper position to the lower position in a state in which the whole area of the upper surface of the substrate W is covered with the liquid film of SC1. Hence, the space inside the shield member 41 is sealed, and the lower surface of the splitter 51 comes into contact with the liquid film of SC1 on the substrate W as shown in FIG. 10G. When the lower surface of the splitter 51 comes into contact with the liquid film of SC1 on the substrate W, residues, such as particles and SOM, adhering to the lower surface of the splitter 51 are removed by SC1.

After the shield member 41 moves to the lower position, and then the inert gas valve 45v is opened, the gas outlets 42 of the shield member 41 start discharging nitrogen gas. Hence, the upper space SP1 of the shield member 41 is filled with the nitrogen gas, and the nitrogen gas flows from the upper space SP1 to the lower space SP2 via the splitter 51. If residues remain in the splitter 51, nitrogen gas that flows out from the lower surface of the splitter 51 discharges the residues outward from the splitter 51. Hence, the residues are removed from the splitter 51.

After the plurality of gas outlets 42 of the shield member 41 start discharging nitrogen gas, a first splitter-drying step (step S8 of FIG. 9) is performed in which the liquid is removed from the splitter 51.

Specifically, the raising/lowering actuator 41a moves the shield member 41 from the lower position to the upper position in a state in which the whole area of the upper surface of the substrate W is covered with the liquid film of SC1, and in which the shield member 41 is positioned at the lower position, and in which the gas outlets 42 of the shield member 41 are discharging nitrogen gas. Hence, the lower surface of the splitter 51 is separated upward from the liquid film of SC1 on the substrate W as shown in FIG. 10H. The nitrogen gas that flows out from the lower surface of the splitter 51 causes SC1 adhering to the lower surface of the splitter 51 to fall down onto SC1 on the substrate W. If SC1 remains in the splitter 51, this nitrogen gas discharges SC1 outward from the splitter 51, and causes SC1 to fall down onto SC1. Hence, the liquid, such as SC1, is removed from the splitter 51. After the liquid is removed from the splitter 51, the splitter 51 may be in a dried state, or may be in a wet state if the liquid is removed to such a degree as not to fall down from the splitter 51.

SC1 is an example of a cleaning liquid that cleans the substrate W and the splitter 51. The cleaning liquid may be a chemical liquid other than SC1, or may be a rinse liquid, such as pure water. Nitrogen gas is an example of cleaning gas that cleans the splitter 51. The cleaning gas may be inert gas other than nitrogen gas, or may be gas other than inert gas, such as clean air.

Thereafter, a second rinse liquid supplying step (step S9 of FIG. 9) is performed in which pure water that is an example of a rinse liquid is supplied to the upper surface of the substrate W.

Specifically, the third nozzle actuator 23a moves the rinse liquid nozzle 23 from the standby position to the processing position in a state in which the substrate W is supported by the hot plate 14 and in which the shield member 41 is positioned at the upper position. Thereafter, the rinse liquid valve 23v is opened. Hence, the rinse liquid nozzle 23 starts discharging rinse liquid as shown in FIG. 10I. After colliding with the upper surface of the substrate W supported by the hot plate 14, the rinse liquid discharged from the rinse liquid nozzle 23 spreads along the upper surface of the substrate W. Hence, SC1 on the substrate W is replaced with pure water, and the whole area of the upper surface of the substrate W supported by the hot plate 14 is covered with a liquid film of the pure water. Thereafter, the rinse liquid valve 23v is closed, and the rinse liquid nozzle 23 stops discharging the pure water. The third nozzle actuator 23a moves the rinse liquid nozzle 23 from the processing position to the standby position in a state in which the rinse liquid nozzle 23 does not discharge the pure water.

Thereafter, a second splitter-cleaning step (step S10 of FIG. 9) is performed in which the splitter 51 is cleaned with both pure water that is an example of a cleaning liquid and nitrogen gas that is an example of cleaning gas.

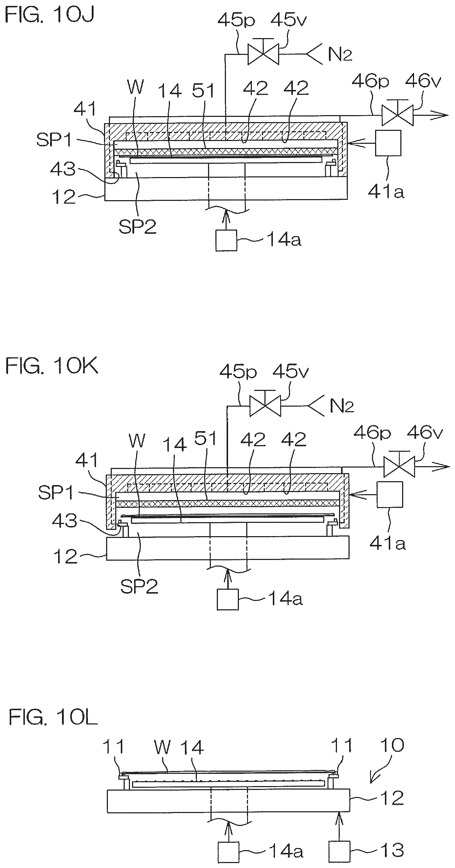

Specifically, the raising/lowering actuator 41a moves the shield member 41 from the upper position to the lower position in a state in which the whole area of the upper surface of the substrate W is covered with a liquid film of pure water. Hence, the space inside the shield member 41 is sealed, and the lower surface of the splitter 51 comes into contact with the liquid film of the pure water on the substrate W as shown in FIG. 10J.

After the shield member 41 moves to the lower position, the inert gas valve 45v is opened, and the gas outlets 42 of the shield member 41 start discharging nitrogen gas. Hence, the upper space SP1 of the shield member 41 is filled with the nitrogen gas, and the nitrogen gas flows from the upper space SP1 to the lower space SP2 via the splitter 51.

After the plurality of gas outlets 42 of the shield member 41 start discharging nitrogen gas, a second splitter-drying step (step S11 of FIG. 9) is performed in which a liquid is removed from the splitter 51.

Specifically, the raising/lowering actuator 41a moves the shield member 41 from the lower position to the upper position in a state in which the whole area of the upper surface of the substrate W is covered with a liquid film of pure water and in which the shield member 41 is positioned at the lower position and in which the plurality of gas outlets 42 of the shield member 41 are discharging the nitrogen gas. Hence, the lower surface of the splitter 51 is separated upward from the liquid film of the pure water on the substrate W as shown in FIG. 10K. The nitrogen gas that flows out from the lower surface of the splitter 51 causes pure water adhering to the lower surface of the splitter 51 to fall down onto pure water on the substrate W. If pure water remains in the splitter 51, this nitrogen gas discharges pure water outward from the splitter 51, and causes the pure water to fall down onto pure water. Hence, the liquid, such as pure water, is removed from the splitter 51. After the liquid is removed from the splitter 51, the splitter 51 may be in a dried state, or may be in a wet state if the liquid is removed to such a degree as not to fall down from the splitter 51.

The shield member 41 is moved to the upper position, and then a substrate receiving/delivering step (step S12 of FIG. 9) is performed in which the substrate W is moved from the hot plate 14 to the chuck pins 11.

Specifically, the raising/lowering actuator 14a moves the hot plate 14 from the upper position to the lower position in a state in which the shield member 41 is positioned at the upper position and in which the plurality of chuck pins 11 have been opened. Hence, the substrate W is placed on the plurality of chuck pins 11, and the hot plate 14 is separated downward from the substrate W as shown in FIG. 10L. Thereafter, the plurality of chuck pins 11 are closed, and the spin motor 13 rotates. Hence, the substrate W held by the plurality of chuck pins 11 starts rotating.

After the substrate W is placed on the plurality of chuck pins 11, a third rinse liquid supplying step (step S13 of FIG. 9) is performed in which pure water that is an example of a rinse liquid is supplied to the upper surface of the substrate W.

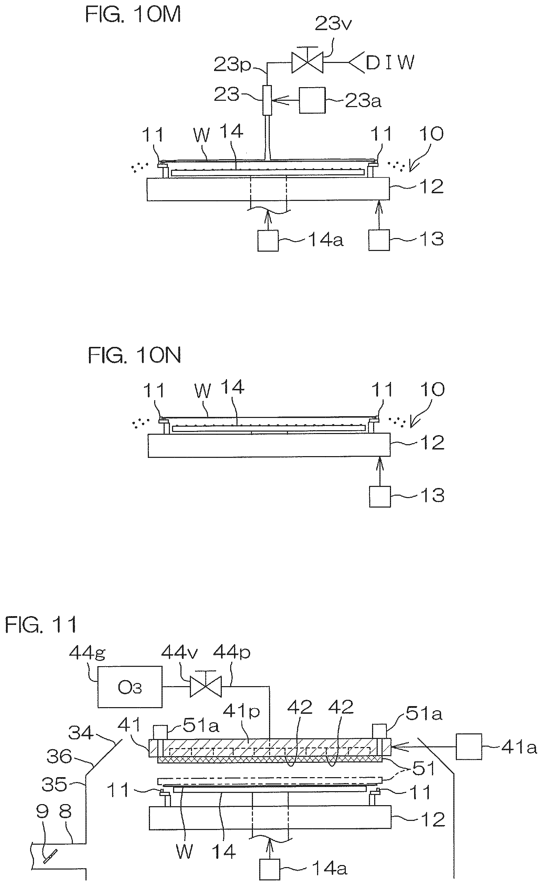

Specifically, the third nozzle actuator 23a moves the rinse liquid nozzle 23 from the standby position to the processing position in a state in which the shield member 41 is positioned at the upper position, and the rinse liquid valve 23v is opened. Hence, the pure water on the substrate W is replaced with new pure water as shown in FIG. 10M, and the whole area of the upper surface of the substrate W held by the plurality of chuck pins 11 is covered with a liquid film of the pure water. Thereafter, the rinse liquid valve 23v is closed, and the third nozzle actuator 23a moves the rinse liquid nozzle 23 from the processing position to the standby position.

After the pure water on the substrate W is replaced with new pure water, a drying step (step S14 of FIG. 9) is performed in which the substrate W is dried by the high-speed rotation of the substrate W.

Specifically, the spin motor 13 accelerates the substrate W in a rotational direction in a state in which discharge of the rinse liquid from the rinse liquid nozzle 23 has been stopped. Hence, the substrate W rotates at a drying speed larger than a rinse liquid supply speed that is the rotation speed of the substrate W indicated when the rinse liquid is supplied to the substrate W. By the substrate W rotating at the drying speed, the liquid is removed from the substrate W and the substrate W is dried as shown in FIG. 10N. Thereafter, the spin motor 13 stops the rotation. Hence, the rotation of the substrate W is stopped in a state in which the substrate W is held by the chuck pins 11.

After the rotation of the substrate W is stopped, a carry-out step (step S15 of FIG. 9) is performed in which the substrate W is carried out from the chamber 4.

Specifically, the plurality of chuck pins 11 are switched from a closed state to an open state. Hence, while the substrate W is being supported by the plurality of chuck pins 11, the substrate W is released from being held by the plurality of chuck pins 11. The raising/lowering actuator 34a lowers all the guards 34 to the lower position at the same time as or before or after the substrate W is released from being held. Thereafter, the center robot CR (see FIG. 1A) causes the hand Hc to enter the inside of the chamber 4. The center robot CR receives the substrate W from the plurality of chuck pins 11, and supports the substrate W by means of the hand Hc. Thereafter, while supporting the substrate W by means of the hand Hc, the center robot CR moves the hand Hc outward from the chamber 4. Hence, the substrate W, which has already been processed, is carried out from the chamber 4.

Next, the advantages according to the preferred embodiment will be described.

In this preferred embodiment, the surface of the splitter 51 is brought into contact with at least either one of a processing liquid that is in contact with the substrate W and a processing liquid that has not yet been in contact with the substrate W. In this state, dissolution gas is caused to flow in a plurality of passages of the splitter 51. The dissolution gas enters the plurality of passages of the splitter 51, and, as a result, is split into a plurality of dissolution-gas lumps that are away from each other. The plurality of passages are opened at the surface of the splitter 51, and therefore the plurality of dissolution-gas lumps go to the outside of the splitter 51 from the surface of the splitter 51. Hence, the plurality of dissolution-gas lumps come into contact with the processing liquid and are dissolved. The dissolution gas is in a split state, and therefore the contact area between the processing liquid and the dissolution gas becomes larger than in a case in which the dissolution gas is brought into contact without being split. This makes it possible to efficiently dissolve the dissolution gas in the processing liquid, and makes it possible to supply the processing liquid in which the dissolution gas is dissolved to the substrate W.

In this preferred embodiment, the contact portion 51c (see FIG. 8) of the surface of the splitter 51 is in contact with the processing liquid, and the dissolution gas is supplied to the noncontact portion 51n of the splitter 51 in a state in which the noncontact portion 51n (see FIG. 8) of the surface of the splitter 51 is away from the processing liquid. The dissolution gas enters the splitter 51 from the noncontact portion 51n of the splitter 51, and goes out from the contact portion 51c of the splitter 51 into the processing liquid. The area in which the dissolution gas can be supplied to the splitter 51 is larger than in a case in which the whole area of the surface of the splitter 51 is in contact with the processing liquid. This makes it possible to supply the dissolution gas to the splitter 51 at a high flow rate.

In this preferred embodiment, a gas area that is an area on the side opposite to a processing liquid with respect to the splitter 51 is filled with dissolution gas. The noncontact portion 51n of the splitter 51 is a portion of a boundary of the gas area. Therefore, it is possible to make the contact area between the dissolution gas and the noncontact portion 51n larger, and to make the flow rate of the dissolution gas entering the splitter 51 from the noncontact portion 51n of the splitter 51 larger than in a case in which the gas area is not filled with dissolution gas.

In this preferred embodiment, a processing liquid is supplied to the substrate W, and then a cleaning liquid, such as SC1, is supplied to the substrate W. Furthermore, the contact portion 51c of the surface of the splitter 51 is brought into contact with the cleaning liquid being in contact with the substrate W. If the processing liquid adheres to the contact portion 51c of the splitter 51, this processing liquid is moved to the cleaning liquid. Hence, the processing liquid is removed from the contact portion 51c of the splitter 51. The substrate W and the splitter 51 are cleaned by the same cleaning liquid, and therefore it is possible to reduce the usage amount of the cleaning liquid. Additionally, the substrate W and the splitter 51 are simultaneously cleaned, and therefore it is possible to shorten a period of time required to clean the substrate W and the splitter 51.

In this preferred embodiment, cleaning gas, such as nitrogen gas, is allowed to flow from the noncontact portion 51n of the surface of the splitter 51 into the plurality of passages of the splitter 51 while bringing the contact portion 51c of the surface of the splitter 51 into contact with a cleaning liquid being in contact with the substrate W. Hence, the cleaning gas that has been split is emitted from the contact portion 51c into the cleaning liquid. If residues, such as a processing liquid or particles, remain in the plurality of passages of the splitter 51, the cleaning gas discharges these residues from the splitter 51. This makes it possible to clean not only the contact portion 51c of the splitter 51 but also the inside of the splitter 51.

In this preferred embodiment, after cleaning the splitter 51, the cleaning gas is caused to flow from the noncontact portion 51n of the surface of the splitter 51 into the plurality of passages of the splitter 51 in a state in which the contact portion 51c of the surface of the splitter 51 is separated from the cleaning liquid being in contact with the substrate W. If a liquid, such as a processing liquid, adheres to the contact portion 51c of the splitter 51, the cleaning gas that flows out from the contact portion 51c of the splitter 51 removes this liquid from the contact portion 51c of the splitter 51. If a liquid remains in the splitter 51, the cleaning gas that flows out from the contact portion 51c of the splitter 51 discharges this liquid to the outside of the splitter 51. This makes it possible to reduce the liquid adhering to the splitter 51.

In this preferred embodiment, the surface of the splitter 51 is brought into contact with the processing liquid contained in the tank 52. In this state, dissolution gas is allowed to flow in the plurality of passages of the splitter 51. The dissolution gas that has entered the plurality of passages of the splitter 51 goes out from the surface of the splitter 51 to the outside of the splitter 51, and is dissolved in the processing liquid contained in the tank 52. This processing liquid is supplied to the substrate W. The dissolution gas is dissolved in the processing liquid in the tank 52, and therefore it is possible to limit the diffusion range of the dissolution gas to the inside of the tank 52, and is possible to reduce the usage amount of the dissolution gas. If the air pressure of the inside of the tank 52 is raised by supplying dissolution gas, it is possible to more efficiently dissolve the dissolution gas in the processing liquid.

In this preferred embodiment, inert gas is supplied into the tank 52 after dissolution gas is dissolved in a processing liquid contained in the tank 52. Hence, the air pressure of the inside of the tank 52 rises to a value at which the processing liquid in the tank 52 is discharged from the tank 52 toward the substrate W. Therefore, it is possible to reduce the usage amount of the dissolution gas and it is possible to reduce the dissolution gas that goes out from the tank 52, as compared to a case in which the processing liquid contained in the tank 52 is pressed and sent by supplying the dissolution gas. If the dissolution gas is a gas, such as ozone gas, that has reactivity, it is possible to restrain or prevent the dissolution gas that has gone out from the tank 52 from reacting with a member placed in the chamber 4 housing the substrate W. Additionally, it is possible to send the processing liquid from the tank 52 to the substrate W without using a pump, and therefore it is possible to prevent a pump from being corroded by the dissolution gas, such as ozone gas.

In this preferred embodiment, the surface of a porous body that is an example of the splitter 51 is brought into contact with a processing liquid. In this state, dissolution gas is supplied to the porous body. The porous body forms a plurality of irregular passages that are opened at the surface of the porous body inside the porous body. When the dissolution gas is supplied to the porous body, the dissolution gas that has been split flows out from the surface of the porous body. The surface of the porous body is a concave-convex surface. If the outline shape and the size are the same, the concave-convex surface is larger in the surface area than a flat surface. Therefore, it is possible to increase the contact area between the processing liquid and the porous body, and it is possible to increase the contact area between the processing liquid and the dissolution gas.

Next, other preferred embodiments will be described.

When the shield member 41 having the cylindrical portion 41t is disposed at the lower position, the plurality of chuck pins 11 may be disposed outside the cylindrical portion 41t.

In a state in which the upper surface of the substrate W is covered with a liquid film of the processing liquid, the substrate W may be heated while being rotated. Specifically, in a state in which the upper surface of the substrate W is covered with a liquid film of the processing liquid and in which the hot plate 14 is separated downward from the substrate W, the hot plate 14 may be caused to heat the substrate W while rotating the substrate W held by the plurality of chuck pins 11.

The dissolution gas may be supplied, via the splitter 51, to only one of the processing liquid that is in contact with the substrate W and the processing liquid that has not yet been in contact with the substrate W. In other words, the splitter 51 may be disposed only above the substrate W or only in the tank 52.

If the splitter 51 is disposed only in the tank 52, the substrate W and the processing liquid may be heated by irradiating light of a lamp that is an example of a heater onto the processing liquid on the substrate W, in addition to or instead of heating the substrate W and the processing liquid by the hot plate 14. The processing liquid in a circulation pathway along which the processing liquid in the tank 52 is circulated may be heated by use of a circulation heater that is an example of a heater. If there is no need to heat the processing liquid, at least one of the hot plate 14, the lamp, and the circulation heater may be omitted.

When the dissolution gas is supplied to the processing liquid via the splitter 51 as shown in FIG. 11, a gap between the shield member 41 and the spin base 12 is not necessarily required to be sealed. Specifically, the cylindrical portion 41t (see FIG. 3) may be omitted from the shield member 41. In this case, the dissolution gas, such as ozone gas, may be suctioned by the discharged gas duct 8. Regardless of whether the shield member 41 has the cylindrical portion 41t or not, the splitter 51 may be movable vertically in parallel with respect to the disk portion 41p of the shield member 41.

FIG. 11 shows an example in which the raising/lowering actuator 51a moves the splitter 51 vertically in parallel between the upper position (position shown by solid line) and the lower position (position shown by the alternate long and two short dashed line). The upper position is a position at which the splitter 51 is separated upward from the processing liquid on the substrate W, and the lower position is a position at which the splitter 51 comes into contact with the processing liquid on the substrate W. When the shield member 41 is disposed at the upper position, the splitter 51 may be in contact with the disk portion 41p, or may be away from the disk portion 41p. When the splitter 51 is disposed at the lower position, a space that diffuses the dissolution gas is formed between the splitter 51 and the disk portion 41p, and therefore it is possible to evenly supply the dissolution gas to the splitter 51.

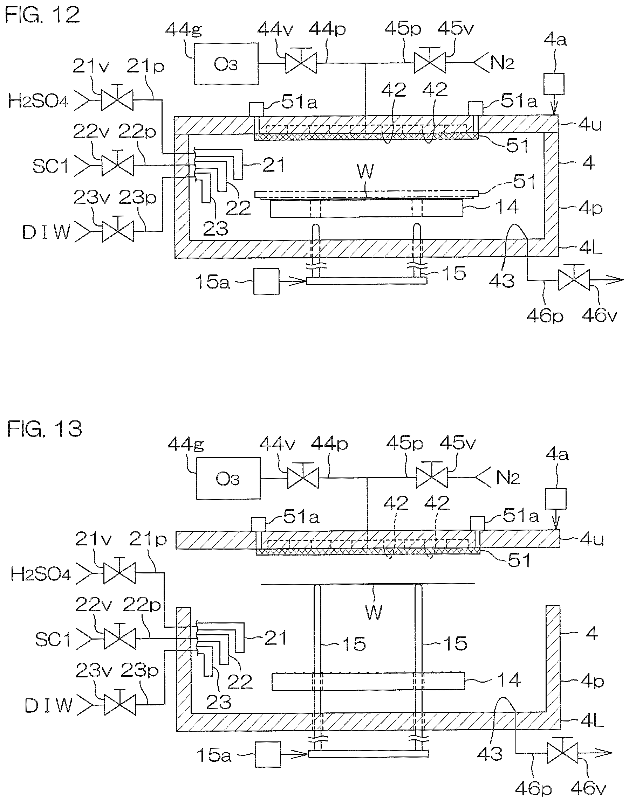

The chamber 4 may be a closed chamber in which the FFU 7 (see FIG. 2) is not provided as shown in FIG. 12 and FIG. 13. FIG. 12 and FIG. 13 each show an example in which the chamber 4 includes an upper wall 4u and a lower wall 4L that are respectively disposed above and below the substrate W and a tubular peripheral wall 4p surrounding the substrate W around a vertical straight line. In this example, the peripheral wall 4p is fixed to the lower wall 4L, and the upper wall 4u is movable vertically in parallel with respect to both the peripheral wall 4p and the lower wall 4L. The opening/closing actuator 4a moves the upper wall 4u vertically in parallel between the lower position (position shown in FIG. 12) at which a gap between the upper wall 4u and the peripheral wall 4p is closed and the upper position (position shown in FIG. 13) at which the substrate W can pass through a space between the upper wall 4u and the peripheral wall 4p.

The hot plate 14 is heated while horizontally holding the substrate W in the chamber 4. As shown in FIG. 13, the substrate W is relayed between the center robot CR (see FIG. 1A) and the hot plate 14 by means of a plurality of lift pins 15 that horizontally support the substrate W. A raising/lowering actuator 15a moves the lift pins 15 vertically in parallel between the upper position (position shown in FIG. 13) that an upper end of the lift pins 15 is positioned at a position higher than an upper end of the peripheral wall 4p and the lower position (position shown in FIG. 12) that the upper end of the lift pins 15 is positioned at a position lower than the hot plate 14.

The first chemical liquid nozzle 21, the second chemical liquid nozzle 22, and the rinse liquid nozzle 23 are disposed in the chamber 4. FIG. 12 and FIG. 13 each show an example in which the first chemical liquid nozzle 21, the second chemical liquid nozzle 22, and the rinse liquid nozzle 23 are stationary nozzles that discharge a processing liquid toward the upper surface of the substrate W on the hot plate 14. As shown in FIG. 12, the splitter 51 is movable vertically in parallel with respect to the upper wall 4u between the upper position (position shown by the solid line) at which the splitter 51 is separated upward from a processing liquid on the substrate W and the lower position (position shown by the alternate long and two short dashed line) at which the splitter 51 comes into contact with the processing liquid on the substrate W.

The substrate processing apparatus 1 is not restricted to an apparatus to process a disc-shaped substrate W, and may be an apparatus to process a polygonal substrate W.

Two or more arrangements among all the arrangements described above may be combined. Two or more steps among all the steps described above may be combined.

The preferred embodiments of the present invention are described in detail above, however, these are just detailed examples used for clarifying the technical contents of the present invention, and the present invention should not be limitedly interpreted to these detailed examples, and the spirit and scope of the present invention should be limited only by the claims appended hereto.

This application claims the benefit of priority to Japanese Patent Application No. 2024-046115 filed on March 22, 2024 and Japanese Patent Application No. 2024-139464 filed on August 21, 2024. The entire contents of these applications are hereby incorporated herein by reference.

## Claims

1. A substrate processing method comprising:
a processing liquid supplying step of supplying processing liquid to a substrate (W); and
a dissolution gas supplying step of dissolving dissolution gas, that has split due to entering a plurality of passages (51h) of a splitter (51), in the processing liquid in a state in which a surface of the splitter (51) including the plurality of passages (51h) that are open at the surface is in contact with at least one of the processing liquid in contact with the substrate (W) and the processing liquid away from the substrate (W).

2. The substrate processing method according to claim 1, wherein the dissolution gas supplying step includes a step of causing the dissolution gas that has split to discharge from a contact portion (51c) of the surface of the splitter (51) into the processing liquid by causing the dissolution gas to flow in the plurality of passages (51h) from a noncontact portion (51n) of the surface of the splitter (51) in a state in which the contact portion (51c) of the splitter (51) is in contact with at least one of the processing liquid in contact with the substrate (W) and the processing liquid away from the substrate (W) and the noncontact portion (51n) of the splitter (51) is away from the substrate (W).

3. The substrate processing method according to claim 2, wherein the dissolution gas supplying step includes a step of filling a gas area (SP1) that is an area on an opposite side of the processing liquid with respect to the splitter (51) with the dissolution gas.

4. The substrate processing method according to any one of claims 1 to 3, further comprising:
a cleaning liquid supplying step of supplying cleaning liquid to the substrate (W) after the processing liquid is supplied to the substrate (W); and
a splitter-cleaning step of causing a contact portion (51c) of the surface of the splitter (51) to be in contact with the cleaning liquid in contact with the substrate (W).

5. The substrate processing method according to claim 4, wherein the splitter-cleaning step includes a step of causing cleaning gas that has split to discharge from the contact portion (51c) into the cleaning liquid by causing the cleaning gas to flow in the plurality of passages (51h) from a noncontact portion (51n) of the surface of the splitter (51) while causing the contact portion (51c) of the surface of the splitter (51) to be in contact with the cleaning liquid in contact with the substrate (W).

6. The substrate processing method according to claim 5, further comprising a splitter-drying step of causing the cleaning gas that has split to discharge from the contact portion (51c) by causing the cleaning gas to flow in the plurality of passages (51h) from the noncontact portion (51n) of the surface of the splitter (51) in a state in which the contact portion (51c) of the surface of the splitter (51) is away from the cleaning liquid in contact with the substrate (W), after the splitter-cleaning step.

7. The substrate processing method according to any one of claims 1 to 6, wherein
the dissolution gas supplying step includes a step of dissolving the dissolution gas, that has split due to entering the plurality of passages (51h) of the splitter (51), in the processing liquid in a state in which the surface of the splitter (51) is in contact with the processing liquid in a tank (52), and
the processing liquid supplying step includes a step of supplying the substrate (W) with the processing liquid supplied from the tank (52).

8. The substrate processing method according to claim 7, wherein the processing liquid supplying step includes a step of increasing gas pressure in the tank (52) to a value at which the processing liquid in the tank (52) is discharged from the tank (52) toward the substrate (W) by supplying inert gas into the tank (52) after the dissolution gas has dissolved in the processing liquid in the tank (52).

9. The substrate processing method according to any one of claims 1 to 8, wherein the splitter (51) is a porous body.

10. A substrate processing apparatus (1) comprising:
a processing liquid nozzle (21) that supplies processing liquid to a substrate (W);
a splitter (51) including a plurality of passages (51h) that are open at a surface of the splitter (51);
a dissolution gas piping (44p, 54p) that discharge dissolution gas to the plurality of passages (51h) of the splitter (51); and
a dissolution gas supplying portion (44g) that supplies the dissolution gas to the dissolution gas piping (44p, 54p),
wherein the dissolution gas supplying portion (44g) supplies the dissolution gas to the dissolution gas piping (44p, 54p) in a state in which a surface of the splitter (51) including the plurality of passages (51h) that are open at the surface is in contact with at least one of the processing liquid in contact with the substrate (W) and the processing liquid away from the substrate (W).
